# EUROPEAN PATENT SPECIFICATION

(11) **EP 3 252 804 B1**
(45) Date of publication and mention of the grant of the patent: **19.05.2021**
(21) Application number: 16172947.0
(22) Date of filing: 03.06.2016
(51) Int. Cl.: H01L 21/67, H01L 21/677

(54) **ELECTROSTATIC DISCHARGE UNIT**
EINHEIT ZUR ELEKTROSTATISCHEN ENTLADUNG
UNITÉ DE DÉCHARGE ÉLECTROSTATIQUE

(43) Date of publication of application: 06.12.2017
(73) Proprietor: Atotech Deutschland GmbH, 10553 Berlin (DE)
(72) Inventor: Skupin, Andreas, 10553 Berlin (DE); Renner, Markus, 10553 Berlin (DE)
(74) Representative: Atotech Deutschland GmbH

(56) References cited:
- WO-A1-2010/090087
- US-A1- 2007 153 153
- US-A1- 2015 034 454

## Description

### Field of the Invention

The present invention refers to a type of electrostatic discharge unit being especially useful for transporting a substrate horizontally. Furthermore, the present invention refers to a method providing an efficient electrical discharge for substrates being transported along a horizontal path.

### Background of the Invention

The industry is already making use of horizontal transport systems, for example, in treatment devices used for the metal deposition on substrates. These metals are, for example, selected from copper, tin or nickel. Such types of depositions are already known for many years. Such depositions represent an essential processing step being used, for example, in the production of printed circuit boards.

Over the years a continuous development resulted from the worldwide technical miniaturization. While providing many benefits it simultaneously provided new challenges for the manufacturers. For example, the foregoing development resulted in a constant need to adapt existing treatment devices for the new substrates and new types of treatment.

For example, the increased requirements regarding chemical stability of the treatment devices led to the usage of completely different materials for the transport rollers especially in the field of electroless chemical and galvanic coating of substrates. For example WO 2011/092131 A1 discloses the usage of glass for such transport rollers. Such transport rollers provide many benefits like a very high chemical stability and a highly accurate production accuracy.

US 2007/153153 discloses a transfer system configured for transporting a substrate, and designed to be able to remove electrostatic charges appearing on the surface of said substrate during transport.

However, as the substrates and treatments are constantly changing there is still a high demand of further improving and adapting the treatment devices. For example, the possibilities of electrically discharging the substrate become more and more important. In this context, it has to be noted that many new substrates are especially sensitive to damages resulting from electrical charges accumulating on the surface of said substrates. However, it can also be beneficial to discharge other substrates being less sensitive to damages themselves, as electrostatic charges accumulating on their surface might affect the handling or even cause explosions even if such substrates are merely transported in an atmosphere containing high levels of certain organic solvents.

It has to be further noted that the treatment devices and transport systems currently in use represent a significant asset value. In fact, the acquisition costs typically amortize over the years or maybe even decades. Simultaneously, long down-times based on greater types of reconstruction also represent a significant loss for the producer, if such reconstructions are possible at all. Thus, it would be highly preferred providing a simple and flexible upgrade system of such treatment devices and transport systems.

Also, there is a continuous demand to increase the reliability of discharging substrates. Based on the increasing price per unit a high amount of damaged substrates result in a significant loss. Furthermore, identifying damages of complex substrates becomes increasingly complicated representing an additional noticeable cost factor. Accepting a certain number of damaged substrates resulting in failures of complex devices like printed circuit boards manufactured herewith, however, results in subsequent costs or even subsequent damages being typically not acceptable. Thus, providing devices ensuring a reliable electrical discharge simplifying the treatment of especially sensitive existing substrates and the next generation of substrates is a particular challenge beneficially to be solved.

### Objective of the present Invention

So there is still a need for transport devices and treatment devices providing an easy and flexible upgrade to maximize the benefit of existing asset values and provide easily customizable new devices.

Furthermore, it would be preferred if corresponding methods and devices for such methods provide an improved electrical discharge for substrates being especially sensitive to accumulation of such electrostatic charges.

Additionally, it would be advantageous if corresponding devices and methods provide a reliable and gentle electrical discharge to ensure an optimized treatment of sensitive substrates.

### Summary of the Invention

The aforementioned problems are solved by the inventions as disclosed in the independent and dependent claims and the description. Further objects and additional benefits are included in the following description, however, even further objects not being explicitly stated herein but being immediately derivable or discernible from the connections discussed herein are solved by the present invention and its embodiments disclosed herein.

The present invention refers to an electrostatic discharge unit containing at least one electrostatic discharge subunit, wherein the at least one electrostatic discharge subunit contains at least one transport roller system and at least one discharge path, wherein each transport roller system independently from each other contains one transport roller and at least one element selected from the group consisting of mountings containing a rolling-element bearing and propulsion elements, the transport rollers are selected from metal transport rollers or polymer coated metal transport rollers, and wherein the electrostatic discharge subunit is adapted to conduct the charge from the surface of the transport roller through the rolling-element bearing, the propulsion element or both to the discharge path.

Such electrostatic discharge units are easily introduced into existing treatments devices and transport systems. Furthermore, such units are easily combined with other elements to provide a construction kit for new treatment devices. Surprisingly, these units are easily introduced into treatment devices and still provide an improved possibility of discharging the substrate despite the limited contact surfaces in the rolling-element bearing and the propulsion elements.

Furthermore, the present invention refers to an electrostatic discharge unit containing at least 2, preferably at least 3, more preferred at least 5, electrostatic discharge subunits, wherein each electrostatic discharge subunit independently from each other contains 1, 2, 3, 4, 5 or 6 transport roller systems and at least one discharge path, each transport roller system contains one transport roller and at least one element selected from the group consisting of mountings and propulsion elements, the transport rollers are selected from metal transport rollers like stainless steel transport rollers or polymer coated metal transport rollers like polymer coated stainless steel transport rollers, and wherein the electrostatic discharge subunits are adapted to conduct the charge from the surface of the transport roller through the mounting, the propulsion element or both to the discharge path.

Such electrostatic discharge units, for example, provide the possibility to construct submodules providing efficient and reliable electrostatic discharge while being easily exchanged according to the specific needs. These submodules provide an excellent balance of good and reliable discharging and a simply construction being easily integrated into an existing or future treatment and/or transport devices.

It proved especially useful using transport roller systems, wherein the charge is conducted through the rolling element bearing. Such systems provided especially increased long term stability.

Furthermore, the present invention refers to a module of a treatment device containing a horizontal transport system for transporting a substrate, wherein the horizontal transport system contains at least one inventive electrostatic discharge unit.

Furthermore, the present invention refers to a treatment device containing at least one inventive electrical discharge unit or at least one inventive module.

Furthermore, the present invention refers to a method for electrical discharging a substrate, wherein the substrate is transported using at least one inventive electrical discharge unit or at least one inventive module.

Furthermore, the present invention refers to the use of at least one inventive electrical discharge unit or at least one inventive module for electrical discharging a substrate.

### Brief Description of the Figures

For a more complete understanding of the present invention, reference is made to the following Detailed Description of the Invention considered in conjunction with the accompanying figures, in which:
Figures 1 to 3 show schematic drawings of rolling-element bearings.
Figure 4 shows a schematic drawing of a ball bearing (24).
Figure 5 shows a schematic drawing of different types of mountings (13).
Figure 6 shows a schematic drawing of a cross section of a rolling-element bearing.
Figure 7 shows a schematic drawing of a side view of the rolling-element bearing of figure 6.
Figure 8 shows a schematic drawing of a rolling-element bearing.
Figure 9 shows the schematic drawing of a mounting similar to the mounting of Figure 6.
Figure 10 shows a schematic drawing of an electrostatic discharge unit.
Figures 11 to 13 show schematic drawings of modules from various directions.

### Detailed Description of the Invention

The present invention refers to an electrostatic discharge unit as disclosed above containing at least one electrostatic discharge subunit, wherein the at least one electrostatic discharge subunit contains at least one transport roller system and at least one discharge path, wherein each transport roller system independently from each other contains one transport roller and at least one element selected from the group consisting of mountings containing a rolling-element bearing and propulsion elements, the transport rollers are selected from metal transport rollers or polymer coated metal transport rollers, and wherein the charge is conducted from the surface of the transport roller through the rolling-element bearing, the propulsion element or both to the discharge path. Preferably, the rolling-elements bearing, the propulsion elements or both contain an organic polymer, and the electrostatic discharge subunit is adapted to conduct the charge from the surface of the transport roller through the organic polymer of the rolling-element bearing, the organic polymer of the propulsion elements or both to the discharge path. It is especially preferred that the rolling-element bearing contains such organic polymer conducting the charge from the transport roller to the discharge path.

It has been noted that conducting the charge through a plain bearing provided long-term problems, as the corresponding bearing seems to suffer unusual abrasion resulting in fine particles being set free and possibly contaminating the treatment device. It is thought that the additives introduced into a polymer being used for such plain bearings weaken the substance and result in an increased vulnerability of such bearings.

Typically, it proved to be especially useful according to further embodiments of the present invention that the inventive electrostatic discharge unit contains at least 2, preferably at least 3, more preferred at least 5 electrostatic discharge subunits each independently from each other containing 1, 2, 3, 4, 5 or 6 transport roller systems.

Furthermore, the present invention refers to an electrostatic discharge unit containing at least 2, preferably at least 3, even more preferred at least 5, electrostatic discharge subunits, wherein each electrostatic discharge subunit independently from each other contains 1, 2, 3, 4, 5 or 6 transport roller systems and at least one discharge path, each transport roller system contains one transport roller and at least one element selected from the group consisting of mountings and propulsion elements, the transport rollers are selected from metal transport rollers or polymer coated metal transport rollers, and wherein the electrostatic discharge subunits are adapted to conduct the charge from the surface of the transport roller through the mounting, the propulsion element or both to the discharge path.

According to specific embodiments it is especially preferred that the inventive rolling-element bearing, the propulsion elements or both contain an organic polymer, and the charge is conducted from the surface of the transport roller through the organic polymer of the rolling-element bearing, the organic polymer of the propulsion elements or both to the discharge path. It is especially preferred that the rolling-element bearing contains such organic polymer conducting the charge. Surprisingly, it was noted that for many embodiments it was especially beneficial introducing an organic polymer conducting the electrical charge. Using such conductive path the number of spark discharges was greatly decreased or even completely reduced to zero.

The embodiments disclosed herein are based on a device for treating substrate, wherein the substrate is transported in a horizontal transport plane. Directions and positions referring to the substrate and elements of the devices described herein are based on the direction of transporting said substrate unless specified otherwise. For example, the above referenced front and end of the electrostatic discharge unit refer to the elements of the corresponding unit where the substrate enters the unit (front) and exits the unit (end). In further embodiments of the present invention the horizontal transport system for transporting a substrate is based on transport rollers being arranged parallel to each other in direction of the transportation route.

The phrase "electrostatic discharge unit" as used herein refers to a device for electrically discharging a substrate coming into contact with it. Such electrostatic discharge units can be used in a great number of applications, however, they proved especially useful in horizontal transport devices. Such horizontal transport devices can be, for example, used in treatment devices allowing an electroless chemical and/or galvanic treatment of substrates. Such treatment can be, for example, used for the deposition of metals like as copper, tin, gold, silver or alloys thereof. Corresponding treatments represent very complex procedures including a great number of different steps including many pretreatment and post treatment steps arranged before, after and between the actual depositions and modification steps of the deposit. Examples of such pretreatment and post treatment steps are rinsing, drying and etching.

The term "mounting" according to the present invention refers to the hanging of said transport rollers containing, for example, some plain bearing or rolling-element bearing, preferably a rolling-element bearing like ball bearing, providing the fastening of the transport rollers while providing the possibility of rotation. Preferably it simultaneously provides an electrical discharge for electrical charges accumulating in the substrate.

The phrase "discharge path" according to the present invention refers to a conductive path like a wire being able to transmit the electrical charge from the mounting to the grounding. Said discharge paths are preferably electrically isolated from each other. However, at least at the ground said discharge paths are connected. Typically, said discharge paths are connected to a central grounding available in a production facility. However, as the connection points at the treatment device are preferably split up into several discharge paths it is secured that the charges are conducted along the different discharge paths without interfering with each other.

The term "transport roller" according to the present invention refers to rollers coming into contact or possibly coming into contact with the substrate to be treated. For example, this term refers to rollers below and above the transport plane coming into contact with the substrate typically being used for forwarding said substrate.

The phrase "transport plane" according to the present invention refers to the plane containing the lower surface of the substrate as it is transported. It has to be understood that said transport plane might not be a perfect geometric plane as there might be some height differences along the path of transportation resulting in a corrugation of said transport plane.

According to further embodiments of the present invention the average electrical resistance of each transport roller system of the electrostatic discharge subunits lies within the range from 10⁴ and 10¹⁰ Ohm, preferably 10⁵ to 5 · 10⁹ Ohm, even more preferred within the range of from 10⁵ to 10⁸ Ohm. The term "average electrical resistance of the transport roller system" refers to the average resistance between the surface of the transport roller adapted to contact the substrate and the outer contact point of the mounting or the propulsion element towards the discharge path. If the transport rollers system contains a mounting and a propulsion element being directly connected to a grounding, it is referred to the element providing the lower average resistance provides the aforementioned electrical resistance. The electrical resistance of the propulsion element is measured analogue to the electrical resistance referring to the mounting. However, as the propulsion element may take various forms and said element additionally actuates the transport roller the outer contact point of the propulsion element might be, for example, located directly at the transport roller or more distant. The outer contact point of the propulsion element is specified being located at the point along the travel path of the charges from the transport roller, wherein the following path towards the grounding is not related to the propulsion of the transport rollers. Preferably, said further path provides a resistance of less than 10⁴ Ohm. For example, the propulsion element might be a conductive driving belt, wherein at some point a sliding contact conducts the charges through some cable towards the grounding. Or, for example, the propulsion element can be a row of gear wheels being mechanically coupled with a single gear wheel being rotated by a drive axle, wherein said drive axle is contacted by such sliding contact. In these cases the contact point of the sliding contact is the outer contact point. Herein, it is preferred to take at least 10, for example 10, more preferred at least 50, for example 50, measurements of said resistance and calculate their arithmetic mean.

Using a gear wheel mechanism as propulsion element proved to be especially useful for a broad range of treatments. If the charges from the transport rollers should be conducted through such propulsion element containing gear wheels the gear wheels preferably contain an electrical conductive coating or are made of an electrical conductive material like a conductive organic polymer, metal, mixtures thereof or combinations thereof, preferably they are made of an electrical conductive material like a conductive organic polymer, metal, mixtures thereof or combinations thereof. Using a combination of multiple gear wheels made from a conductive organic polymer and metal, for example, provides the benefit that a kit of gear wheels can be provided enabling to easily adapt the resulting electrical resistance based on exchanging single gear wheels according to the present needs. Possible metals for such gear wheels are, for example, steel like stainless steel, titanium and aluminum.

According to further embodiments the electrical resistance of the mounting, the propulsion element or both, preferably of the mounting, being adapted to conduct the charges towards the grounding lies within the range from 10³ to 10⁹ Ohm, more preferred within the range of 10⁴ to 5 · 10⁹ Ohm, even more preferred within the range of 5 · 10⁴ to 5 · 10⁸ Ohm. The electrical resistance is preferably measured between the contact point of the transport roller and the bearing and the outer contact point of the mounting or the contact point of the transport roller and the propulsion element and the outer contact point of the propulsion element in direction of the discharge path. If the transport rollers system contains a mounting and a propulsion element being directly connected to a grounding, it is preferably referred to the element providing the lower average resistance.

Typically, the mounting contains at least an inner part and an outer part, wherein the inner part and the outer part are made from different materials. Preferably, the outer part is made from a metal like steel aluminium or titanium, an alloy like steel or hastelloy, a conductive polymer or sintered carbon, more preferred a metal or an alloy, even more preferred an alloy. An especially preferred metal is titanium. An especially preferred alloy is steel. Said inner part preferably contains the bearing like a rolling-element bearing or plain bearing, more preferred consists of such bearing. Rolling-element bearings typically proved to be especially useful for such inner part.

According to further embodiments of the present invention at least 3 electrostatic discharge subunits of the inventive electrostatic discharge unit independently from each other contain at least 2, preferably at least 3, even more preferred at least 4, transport roller systems.

Furthermore, it has been noted that for many typical applications it is beneficial to use a certain number of transport roller systems taking into account the number of discharge paths. In more detail, it is preferred according to further embodiments that the number of transport roller systems is at least 1.3 times, preferably at least 1.5 times, even more preferred at least 1.9 times, the number of discharge paths, based on the total number of transport roller systems and discharge paths in the electrostatic discharge unit.

In further embodiments of the present invention the average electrical resistance of the electrostatic discharge subunits contained in the electrostatic discharge unit is between 5 · 10³ and 5 · 10⁸ Ohm, preferably is between 10⁴ and 7 . 107 Ohm, more preferred is between 10⁵ and 2 · 10⁷ Ohm, per metre length of the transport rollers, based on the average resistances of the transport roller systems. Preferably, said ranges of electrical resistance apply to all transport rollers of the electrostatic discharge subunits contained in the electrostatic discharge unit. Herein, the total length of the transport roller is used to calculate said ratio. Surprisingly, it has been noted that electrostatic discharge units providing such resistances typically represented especially reliable discharge systems simultaneously providing a gentle discharge of accumulated charges of the substrates.

In further embodiments of the present invention only 2, preferably only 1, electrostatic discharge subunit of the electrostatic discharge unit each provide at least 4, preferably at least 3, transport rollers above the transport plane. Typically, it is preferred that the aforementioned electrostatic discharge subunits containing at least 4, preferably at least 3, transport rollers above the transport plane are located at the front and at the end of the electrostatic discharge unit.

According to further embodiments of the present invention the electrostatic discharge unit contains at least 4, preferably at least 6, even more preferred at least 8 inventive electrostatic discharge subunits. It appears that the usage of a higher number of electrostatic discharge subunits allows realizing longer transportation paths still providing an efficient and reliable discharging. Such embodiments are, for example, especially useful, if a substrate has to be dried and the drying process requires a longer transportation path to be completed.

Furthermore, it is preferred in further embodiments that at most 3, more preferred at most 2, electrostatic discharge subunits of the inventive electrostatic discharge unit are separated by one transport roller not being part of an electrostatic discharge subunit being located between the transport rollers below the transport plane of the electrostatic discharge subunits. Especially, it is preferred that the electrostatic discharge subunits of the inventive electrostatic discharge unit are not separated by transport rollers being not part of an electrostatic discharge subunit. It has been noted that according to many to most embodiments of the present invention it is beneficial to provide an essentially continuous row of inventive transport rollers. Although, the inventive electrical discharge units still provide a benefit in other embodiments the inventive effect is typically greatly increased using such aforementioned essentially continuous arrangement of inventive electrostatic discharge subunits.

Furthermore, it has been noted that according to further embodiments it is typically preferred that the transport rollers below the transport plane are not in contact with a liquid bad. Naturally, the transport rollers might come into contact with a liquid, for example, based on fluid being introduced by wet substrates coming into contact with said rollers. However, the beneficial results seem to typically decrease, if the transport rollers below the transport plane are in contact with a bath.

According to further embodiments of the present invention the mountings of at least one electrostatic discharge subunit are connected to a conductive rail, conductive frame or combinations thereof and said conductive rail, conductive frame or combinations thereof is grounded. Preferably, said conductive rail and conductive frame is made of metal. Said conductive rail and conductive frame typically provides no essential electrical resistance. For example, their greatest electrical resistance between a mounting of the electrostatic discharge subunit and the grounding is preferably less than 1 Ohm, preferably less than 0.1 Ohm, even more preferred less than 0.01 Ohm. In further embodiments of the present invention the mountings of most, more preferred at least 90 %, even more preferred all, inventive electrostatic discharge subunits are connected according to the above described way. It has been noted that such arrangement surprisingly provides a very easy and reliable possibility of grouping otherwise isolated transport roller systems providing high mechanical stability as well as good performance.

The phrase "conductive rail" according to the present invention refers to a conductive element being located on at least one side of the mounting and being no conductive frame. For example, a metal bar or board can be used for such purpose. Using such elements as part of the discharge path requires less material to be used compared to conductive frames and still provides a reliable discharge. Furthermore, using conductive rails provide simple and efficient constructions with many possibilities of movement.

For example, it is preferred in other embodiments to connect the transport rollers above the transport plane of at least 3, more preferred at least 4, even more preferred at least 6, electrostatic discharge subunits to the corresponding discharge path using a vertical conductive rail or the vertical conductive rail part of the combination of a conductive frame and conductive rail. Such type of connecting said transport rollers provide a simple and reliable possibility to connect the transport rollers above the transport plane while providing the possibility of vertical movement of said transport rollers.

The phrase "conductive frame" according to the present invention refers to a conductive element being located around a mounting. For example, such conductive frames can be made by bending or welding metal bars or boards.

In further embodiments of the present invention the bearing of the mounting is made from a self-lubricating organic polymer. Such systems proved to be especially beneficial for typical embodiments, as they typically allow avoiding the use of lubricants reducing the risk of contamination of the treatment area. Said bearing of the mounting and the corresponding part of the transport roller can be, for example, in direct contact with each other like in a plain bearing or separated by another part of the bearing and rolling element like in a rolling-element bearing.

The phrases "organic polymer" and "organic polymeric coating" refer to organic polymeric materials and coatings made therefrom used in the art. Said organic polymer can contain fillers, lubricants, plasticizer and further typical additives known in the art. Such additives often influence the properties of the organic polymer and, for example, influence the conductivity of the resulting material.

The mountings preferably contain plain bearings, rolling-element bearings or mixtures thereof. Herein, the rolling-element bearing proved to be especially useful, as they typically provided a greater lifetime and less abrasion being very beneficial for many applications. An especially preferred type of rolling-element bearing is the ball bearing.

The material of the rolling-elements or balls of said rolling-element bearings or ball bearings can be selected from those known in the art providing the required conductivity for conducting the charges from the transport rollers to the discharge paths. Examples of materials to be used are metals and electrically conductive polymers, preferably metals like steel or tungsten carbide, more preferred steel. Such rolling-elements or balls are readily available and provide good characteristics to be used in such mounting. According to further embodiments it is especially preferred that the charges are conducted through the rolling element of the rolling-element bearing towards the grounding.

The bearing surfaces of the plain bearings, rolling-element bearings like ball bearings or combinations thereof are preferably made from an organic polymeric material adapted to conduct the electrical charges from the axis of the transport roller to the outer side of the mounting. It is especially preferred that the organic polymeric material is a self-lubricating organic polymer to reduce or even avoid the use of lubricants. Such mountings combine various beneficial characteristics for most applications, as they provide a very easy and yet quiet operation being applicable for a broad range of transport rollers of different weights.

It has to be understood that the inventive transport roller systems might only contain 1 mounting, wherein the other side can, for example, be a gear wheel being coupled to other gear wheels providing the rotation of the transport roller. However, typically it is preferred to provide 2 mountings to provide a simple and tough attachment of the transport roller and introduce the kinetic energy using separate means like a gear wheel or driving belt mechanism. For example, the transport roller can provide 2 mountings and a gear wheel mechanism providing the rotation of the transport roller.

According to further embodiments of the present invention the organic polymeric coating of the polymer coated metal rollers, preferably stainless steel rollers, is an organic polymer with low or essentially no electrical conductivity, preferably with an resistivity of at least 10³ Ohm · m, more preferred at least 10⁶ Ohm · m, even more preferred at least 10⁸ Ohm · m. Surprisingly, it had been noted that using an organic polymer with high electrical conductivity in some specific applications resulted in a less pronounced decrease of the damages of transported substrates. It is a theory, that a very low conductivity towards the transport roller enables a very quick discharge of electrical charges resulting in damages of certain substrates during specific treatments.

In further embodiments of the present invention the mountings of the transport roller systems not being directly connected to a grounding are made from the same or a different material than the mounting on the opposing side being directly connected to a grounding. Examples of materials to be used are organic polymeric materials, metals like steel or aluminum, ceramic materials or combinations thereof, preferably metals like steel or aluminum, organic polymeric materials or combinations thereof. For example, the mountings on both side can contain an inner bearing essentially, preferably completely, consisting of an organic polymeric material and an outer part containing metal, preferably consisting of metal like stainless steel.

The phrase "side being directly connected to a grounding" according to the present invention refers to an element contacting a discharge path allowing to charges to flow from the transport roller through said element to the grounding. The phrases "side not being directly connected to a grounding", "directly connected to a grounding" and "not directly connected to a grounding" according to the present invention are specified accordingly.

In further embodiments of the present invention the organic polymeric coating of the polymer coated metal, preferably stainless steel, rollers contain less than 10 wt.-% additives like fillers and plasticizers based on the total weight of the organic polymeric coating. Surprisingly, it has been noted that using such polymer coated metal, preferably stainless steel, rollers can be used in a great number of different types of treatments. It is a theory that the additives possibly leech out from the organic polymer resulting in problems for specific types of treatments or high amounts of, for example, fillers result in an increased abrasion leading to contamination and changes of the electrical resistance of said transport rollers.

According to further embodiments of the present invention the organic polymeric coating of the polymer coated metal, preferably stainless steel, rollers is essentially free from conductive particles like carbon black, graphite, graphene, carbon nanotubes or metal particles. For example, the organic polymeric coating contain less than 10 wt.-%, more preferred less than 5 wt.-%, even more preferred less than 1 wt.-%, conductive particles. Especially, it is preferred that said organic polymer does not contain such conductive particles. Surprisingly, it has been noted that reducing the amount of such particles seems to improve the overall life time of said coating and to reduce the amount of abrasion products.

According to further embodiments of the present invention the organic polymeric coating of the polymer coated metal, preferably stainless steel, rollers contain at least 90 wt.-%, more preferred at least 95 wt.-%, even more preferred at least 99 wt.-%, of the organic polymer, based on the total weight of the organic polymeric coating. It has been noted that using essentially pure polymers with greatly reduced amounts of additives provided a more reliable system to be used in different types of treatments using a broad range of chemicals. If mixtures or combinations of organic polymers are used the total amount of these organic polymers is used for calculation.

In further embodiments of the present invention at least 90 wt.-%, preferably at least 95 wt.-%, even more preferred at least 99 wt.-%, of the organic polymer is selected from the group consisting of EPDM, NBR, CR, fluoropolymer elastomers, mixtures thereof or combinations thereof, preferably EPDM, NBR, fluoropolymer elastomers, mixtures thereof or combinations thereof, more preferred EPDM, based on the total amount of organic polymer. It is especially preferred that at least the organic polymer coated onto the transport roller is selected that way. It has to be noted that the total amount of organic polymer refers to the organic polymers used therein and does not include additives like fillers or plasticizers that might be contained therein. The aforementioned terms refer to the commonly known meaning known in the art. For example, EPDM refers to ethylene propylene diene monomer rubber. NBR represents the abbreviation of nitrile butadiene rubber, whereas CR stands for polychloroprene. Examples of fluoropolymer elastomers are named VITON.

According to further embodiments of the present invention each discharge path of the inventive electrostatic discharge subunits is connected to at most 3 transport rollers below the transport plane and at most 3 transport rollers above the transport plane. Surprisingly, such systems already provided a great improvement for many treatments without requiring specifically adapting the system to the specific type of treatment and substrate.

In further embodiments of the present invention the average thickness of the organic polymeric coating of the polymer coated metal, preferably stainless steel, transport rollers is less than 5 mm, more preferred less than 3.5 mm, even more preferred less than 3 mm. The thickness of the organic polymer layer on the transport rollers is measured using standard methods. For example, the organic polymer layer can be cut from the transport roller and be measured using a sliding calliper. However, the person skilled in the art is able to choose different measurement methods if required.

Unless specified otherwise the "average" value as used herein refers to the arithmetic mean of said value calculated based on the sum of a certain number of values divided by their number (average value = sum of measured values / number of measured values). To achieve a statistical significant value at least a certain number of values have to be used for calculating said value, for example, at least 10, for example 10, values. The number of measurements, however, can be increased, for example, to at least 50, for example 50, or at least 100, for example 100, if the fluctuation of the values is high. Referring to the average thickness of the organic polymeric coating at least 10 measurements are taken, wherein the measurements are randomly selected and located in the area of the transport roller adapted to contact the substrate.

According to further embodiments of the present invention at least one, preferably most, more preferred at least 75 %, even more preferred at least 90 %, even more preferred all, of the mountings of the electrostatic discharge subunits of the electrostatic discharge unit are connected to a conductive rail, conductive frame or combinations thereof and said conductive rail, conductive frame or combinations thereof is grounded. Preferably, said conductive rail, conductive frame and combinations thereof are made of metal. The conductive rail, conductive frame and combinations thereof typically essentially provide no electrical resistance. For example, according to further embodiments the greatest electrical resistance between a mounting of the electrostatic discharge subunit and the grounding is less than 1 Ohm, preferably less than 0.1 Ohm, even more preferred less than 0.01 Ohm.

In further embodiments of the present invention the electrical resistance of each transport roller system is in the range from 10⁴ to 10¹⁰ Ohm, preferably in the range from 5 · 10⁴ to 10⁹ Ohm, even more preferred in the range from 10⁵ to 10⁸ Ohm. Surprisingly, it was noted that the overall electrical resistance is typically beneficially adjusted in such range to provide an improved electrical discharge for typical application.

In further embodiments of the present invention the thickness of the organic polymeric coating of the polymer coated metal, preferably stainless steel, transport rollers in the area adapted to contact the substrate is at most 7 mm, more preferred at most 6.2 mm, even more preferred at most 5.3 mm. It has been noted that for polymeric coatings providing, for example, a low conductivity being beneficially used according to the present invention should provide a high degree of uniform coating. In such cases, even single spots providing a too thick coating seem to decrease the benefit obtained with the present invention.

The term "adapted to contact the substrate" refers to an area of an object possibly coming into contact with the substrate while being transported, for example, over corresponding transport rollers. For example, as the substrates to be transported or treated typically provide a width smaller than the width possible in the corresponding device multiple paths to travel along are possible and a single substrate, thus, does not come into contact with said whole area.

In further embodiments of the present invention the highest thickness of the organic polymeric coating of the polymer coated metal, preferably stainless steel, transport rollers adapted to contact the substrate is at most 150 %, more preferred at most 130 %, even more preferred at most 120 %, of the average thickness of the coating.

According to further embodiments of the present invention the lowest thickness of the organic polymeric coating of the polymer coated metal, preferably stainless steel, transport rollers adapted to contact the substrate is at least 50 %, more preferred at least 60 %, of the average thickness of the organic polymeric coating.

According to further embodiments of the present invention the average thickness of the organic polymeric coating adapted to contact the substrate of the polymer coated metal, preferably stainless steel, transport rollers is at least 0.7 mm, more preferred at least 0.8 mm, even more preferred at least 1 mm. Preferably said thickness refers to the whole polymer coating of the polymer coated transport rollers. It appears that the beneficial effects of organic polymeric coated steel rollers as disclosed herein providing areas coming into contact with the substrate and providing a very thin coating provide less pronounced benefits in certain applications.

In further embodiments of the present invention the metal, preferably stainless steel, transport rollers or polymer coated metal, preferably stainless steel, transport rollers are pipes. It has been noted that such transport rollers typically provide the required stability and conductivity for the inventive applications while simultaneously providing a greatly decreased weight and inertia.

According to further embodiments of the present invention at least one gas supply element is located around the transport rollers. Herein, it is especially preferred that the gas is directly or indirectly directed onto the substrate. The term "around" the transport rollers according to the present invention refers to an arrangement of said gas supply elements, wherein those elements are arranged above, below or beside the transport rollers. Also a combination of multiple arrangements might be used.

In further embodiments of the present invention the at least one gas supply element contains an end part and at least 90 %, preferably at least 99 %, even more preferred all, of the surface of the inside of the last 30 cm of said end part are made from an electrical conductive material and said surface on the inside of the end part is grounded.

The term "end part" in this context refers to the end of the gas supply element containing the gas outlet from which the gas exits the gas supply element. It has to be understood that the grounding is not necessarily connected at said last 30 cm of the end part. For example a conductive path might be included throughout the gas supply element to conduct the charges from said end part to a different part of the treatment device. Furthermore, it is possible to use several groundings to provide alternative possibilities to discharge the gas stream in case one grounding is disconnected, for example, based on an accident during cleaning or during movement of the gas supply element. Although, it is typically enough to use at least one grounding, it is preferred in specific embodiments to include at least 2 or at least 3 groundings. The terms used in connection with the gas supply element are named in relation to the gas stream. For example, the terms end part of the gas supply element and last part of said element refer to the outlet of the gas supply element. According to further embodiments of the present invention at least the end part and the base of the gas supply element are grounded.

The term "base" of the gas supply element according to the present invention refers to the connecting part of the gas supply element and the wall of, for example, the module of a treatment device.

According to further embodiments of the present invention at least 90 %, preferably at least 95 %, more preferred at least 99 %, even more preferred 100 %, of the inside of the at least one gas supply element from the base of the gas supply element to its outlet is made from an electrical conductive material, the base of the gas supply element is grounded and at least the last 30 cm of the end part are electrically connected to the base, or said at least 30 cm of the end part are separately.

According to further embodiments of the present invention the gas supply element is used for gases containing at least 50 vol-%, preferably at least 70 vol.-%, more preferred at least 80 vol-%, even more preferred at least 99 vol-%, nitrogen, based on the total volume of said gas at 1 bar.

In further embodiments it is preferred that a rotation of the outer part of the mountings conducting the charges towards the discharge path is reduced or prevented. Such embodiments typically provide a higher reliability of discharging the substrate. The prevention of the rotation is accomplished, for example, by choosing a corresponding form of the outer side of the mounting or fixing the outer element of the mounting by means of, for example, screws or bolts. In more detail, an outer form of the mounting can be chosen providing at least one corner or a bulge, wherein said corner or bulge comes into contact with fixed element of the module preventing a further rotation of said mounting. For example, a conductive rail, conductive frame or combinations thereof can be used as fixed element. Typically, it is preferred that 90%, more preferred 95%, even more preferred all, of the mountings of the electrical discharge subunits being directly connected to a grounding provide such reduced possibility of rotation.

According to further preferred embodiments of the present invention the rotation of the mounting is reduced or prevented using corner and/or bulges of the aforementioned mountings. This option provided a simple structure and simultaneously a surprisingly high efficiency of contacting the mounting. In further embodiments the mountings provide a form containing at least two elements of the group consisting of corners, bulges or mixtures thereof limiting the possible rotation of said mounting to less than 50°, preferably to less than 30°, even more preferred to less than 20°: Such prevention of the rotation resulted in an improved life expectancy of contacts and cables used for contacting the mounting with the discharge path. Furthermore, it allowed the use of shorter cables resulting in savings of material as well as reducing the risk of people getting caught on loose cables.

In further embodiments of the present invention the mountings of the electrical discharge units being directly connected to a grounding directly contact a conductive rail, a conductive frame or combinations thereof by means of their edges or bulges to allow the flow of the charges towards the grounding. Surprisingly such embodiments also provided a very high reliability and simultaneously rendered it possible to reduce or even avoid the use of cables at these mountings.The reduction of cables being a possible safe risk based on people getting caught reduces the rate of accidents and number of people getting hurt.

The outer forms of corresponding mountings can be selected, for example, from cuboids or cubes. However, also asymmetric forms can be used. For example, a cylinder with elliptical or circular base might be used, wherein on at least one side of the cylinder a part of the curved surface area is cut off resulting in a plane surface at this side providing two edges at the sides of the plane surfaces adjoining the remaining curvature of the side of the cylinder. Such structure can be easily produced from readily available mountings and can easily be adapted to the requirements of specific treatment devices rendering it especially useful for upgrading existing treatment devices.

Alternatively or additionally, said mountings can be fixated at a certain point using, for example, screws or bolts. Such structure also provides the aforementioned benefits and even reduces the rotation even more. However, such strictly fixed mountings appear to suffer from an increased material fatigue.

Typically, it is preferred that 90%, more preferred 95%, even more preferred all, of the mountings of the electrical discharge units being directly connected to a grounding provide such reduced possibility of rotation using, for example, corner, bulges, screws or bolts.

Furthermore, the present invention refers to a module of a treatment device containing a horizontal transport system for transporting a substrate, wherein the horizontal transport system contains at least one inventive electrostatic discharge unit.

The term "module" as used herein refers to a subunit of a treatment or transport device providing delimitation from the other parts of said treatment or transport device. Using such modules allows an easy arrangement according to the specific requirements of the customer and the possibility to upgrade or adapt the corresponding device later on. For example, it can provide certain delimitations like walls, weirs or transport roller arrangements to the neighbouring modules or the beginning or end of the treatment or transport device. Typically, the substrate enters the module through an inlet and leaves it through some outlet to reduce or avoid the exchange of fluids or gases between the modules. Besides a physical delimitation a module can also be defined by a specific function within the treatment apparatus. Preferably, the inventive modules provide closed space volumes allowing an exchange with its exterior only through specified openings like said inlet and outlet.

According to further embodiments of the present invention more than 50 %, more preferred more than 70 %, even more preferred more than 90 %, of the transport rollers of the module are part of an inventive electrostatic discharge unit. It has been noted that providing a higher ratio of the inventive transport rollers resulted in a significant decrease of damages occurring on substrates being especially sensitive towards electrostatic damages.

The mountings can, for example, be placed inside a module, in the wall of a module or on the outside of a module. Typically, it is preferred placing the mountings being directly connected to a grounding in the wall of a module or at least partly outside of the module, more preferred at least partly outside of the module. Such embodiments typically provide a far easier structure and maintenance of corresponding devices.

In many cases it is preferred that the mountings adapted to conduct the charges from the transport roller to the discharge path of at least 1, more preferred all, inventive electrostatic discharge subunit are located on the outside of the module.

Typically, it is often preferred that at least 90%, preferably at least 95%, even more preferred all, of the mountings being directly connected to a grounding of the electrostatic discharge unit do not reach into the inside of the module.

The additional benefit in case the aforementioned specified localization of the mountings also refers to mountings not being directly connected to a grounding is typically less pronounced. However, typically it is still preferred that the aforementioned localizations also refer to mountings not being directly connected to a grounding. Preferably, the same localization is used for all mountings of the inventive transport roller systems. It has surprisingly been noted that the typically increased lifetime and identical maintenance interval in case of using such structure typically surpasses the additional requirements and costs resulting therefrom.

Typically, it is further preferred that the same mountings are used on both sides of the transport rollers whether they are directly connected to a grounding or not. It has been noted that using mountings providing different electrical resistances while providing the same or similar outward appearances might possibly result in an incorrect placement of said mountings reducing or even negating the beneficial effects of the inventive electrical discharge unit.

In further embodiments of the present invention at least one electrostatic discharge unit of the inventive module provides a gas supply element as specified above. It has been noted that using at least one of such electrostatic discharge units, for example, greatly improves the benefit of the inventive modules in dry modules and increases the safety when handling explosive or flammable gases.

According to further embodiments of the present invention the module contains only 2, preferably only 1 inventive electrostatic discharge unit. It has been noted that typically it is preferable to use a specific type of such electrostatic discharge unit based on the specific requirements of the corresponding module. Including a greater variety is possible, however, in most cases does not result in a benefit compensating the increased complexity.

Furthermore, it has been noted that a higher benefit typically is to be expected in cases, wherein the transport rollers of the inventive module are not in contact with a liquid during operating said module.

Also it appears that the greatest benefit is available for modules, wherein the substrate is contacted with at least one inventive electrical discharge unit or moved through an inventive module while being dried or being in a dry state. In such cases the danger of electrostatic damages seems to be the greatest und using the inventive electrostatic discharge unit provided the biggest benefit.

Furthermore, the present invention refers to a treatment device containing at least 1, preferably at least 2, even more preferred at least 3, of the inventive electrical discharge units and/or at least 1, preferably at least 2, inventive modules.

Such treatment device is, for example, selected from devices used for electroless chemical treatment, galvanic treatment or combinations thereof. Such treatment devices are, for example, used in the manufacture of printed circuit boards continuously providing new demands regarding the substrates and their handling.

Furthermore, the present invention refers to a method for electrical discharging a substrate, wherein the substrate is transported using at least one inventive electrical discharge unit or at least one inventive module.

In further embodiments of the present invention the substrate is transported while being in a dry state. It has been noted that the inventive method is especially beneficially applied to substrates being in a dry state resulting is a very significant decrease of the number of damaged treated substrates occurring during processing said substrates.

According to further embodiments of the present invention the substrate includes a guiding element located on at least one, preferably at least two, sides of the substrate, covering less than 10 % of the surface of the substrate. Surprisingly, it has been noted that the treatment of very flexible substrates has been improved despite the distance of the substrate and the grounded transport rollers resulting from the thickness of such guiding element. Said guiding element can be, for example, in the form of plates or rods being attached to at least one side of the substrate. Said attachment to the substrate can be, for example, based on a hook mechanism, clamping mechanism or gluing or taping the substrate to the guiding element.

Furthermore, the present invention refers to a use of at least one inventive electrical discharge unit or at least one inventive module for electrical discharging a substrate.

Additionally, the present invention refers to a use of at least one inventive electrical discharge unit or at least one inventive module for the production of a printed circuit board, a printed circuit foil, a semiconductor wafer, a solar cell or a photoelectric cell.

According to an aspect 1 the present invention preferably refers to an electrostatic discharge unit containing at least one electrostatic discharge subunit, wherein the at least one electrostatic discharge subunit contains at least one transport roller system and at least one discharge path, wherein each transport roller system independently from each other contains one transport roller and at least one element selected from the group consisting of mountings containing a rolling-element bearing and propulsion elements, wherein the transport rollers are selected from metal transport rollers or polymer coated metal transport rollers, and wherein the electrostatic discharge subunit is adapted to conduct the charge from the surface of the transport roller through the rolling-element bearing, the propulsion element or both to the discharge path.

According to an aspect 2 the present invention preferably refers to the electrostatic discharge unit according to aspect 1, wherein the rolling-element bearing, the propulsion elements or both contain an organic polymer, and wherein the charge is conducted from the surface of the transport roller through the organic polymer of the rolling-element bearing, the organic polymer of the propulsion elements or both to the discharge path.

According to an aspect 3 the present invention preferably refers to the electrostatic discharge unit according to any of aspects 1 to 2, wherein the electrostatic discharge unit contains at least 3, preferably at least 4, more preferred at least 5 electrostatic discharge subunits each independently from each other containing 1, 2, 3, 4, 5 or 6 transport roller systems.

According to an aspect 4 the present invention preferably refers to an electrostatic discharge unit containing at least 2, preferably at least 3, even more preferred at least 5, electrostatic discharge subunits, wherein each electrostatic discharge subunit independently from each other contains 1, 2, 3, 4, 5 or 6 transport roller systems and at least one discharge path, wherein each transport roller system contains one transport roller and at least one element selected from the group consisting of mountings and propulsion elements, wherein the transport rollers are selected from metal transport rollers or polymer coated metal transport rollers, and wherein the electrostatic discharge subunits are adapted to conduct the charge from the surface of the transport roller through the mounting, the propulsion element or both to the discharge path.

According to an aspect 5 the present invention preferably refers to the electrostatic discharge unit according to aspect 4, wherein the mounting contains a rolling-element bearing.

According to an aspect 6 the present invention preferably refers to the electrostatic discharge unit according to any of aspects 1 to 5, wherein the mounting, the propulsion elements or both, preferably the mounting, contains an organic polymer, and wherein electrostatic discharge subunits are adapted to conduct the charge from the surface of the transport roller through the organic polymer of the mounting, the organic polymer of the propulsion elements or both to the discharge path.

According to an aspect 7 the present invention preferably refers to the electrostatic discharge unit according to any of aspects 1 to 6, wherein the electrical resistance of the mounting, the propulsion element or both, preferably of the mounting, being adapted to conduct the charges towards the grounding lies within the range from 10³ to 10⁹ Ohm, more preferred within the range of 10⁴ to 5 · 10⁹ Ohm, even more preferred within the range of 5 · 10⁴ to 5 · 10⁸ Ohm.

According to an aspect 8 the present invention preferably refers to the electrostatic discharge unit according to any of aspects 1 to 7, wherein at least one, preferably most, more preferred at least 75 %, even more preferred at least 90 %, even more preferred all, of the mountings of the electrostatic discharge subunits of the electrostatic discharge unit is connected to a conductive rail, conductive frame or combinations thereof and wherein said conductive rail, conductive frame or combinations thereof is grounded.

According to an aspect 9 the present invention preferably refers to the electrostatic discharge unit according to any of aspects 1 to 8, wherein the organic polymer of the rolling-element bearing is a self-lubricating organic polymer.

According to an aspect 10 the present invention preferably refers to the electrostatic discharge unit according to any of aspects 1 to 9, wherein the rolling elements of the rolling-element bearing are made of metal, preferably steel. For example, steel balls can be used if the rolling-element bearing is a ball bearing.

According to an aspect 11 the present invention preferably refers to the electrostatic discharge unit according to any of aspects 1 to 10, wherein the organic polymeric coating of the polymer coated metal, preferably stainless steel, rollers is an organic polymer with low or essentially no electrical conductivity, preferably with an resistivity of at least 10³ Ohm · m, more preferred at least 10⁶ Ohm · m, even more preferred at least 10⁸ Ohm · m.

According to an aspect 12 the present invention preferably refers to the electrostatic discharge unit according to any of aspects 1 to 11, wherein mountings of the transport roller systems not being directly connected to a grounding are made from the same or a different material than the mounting on the opposing side being directly connected to a grounding. Examples of materials to be used are organic polymeric materials, metals like steel or aluminum or ceramic materials, preferably organic polymeric materials or metals, even more preferred organic polymeric materials.

According to an aspect 13 the present invention preferably refers to the electrostatic discharge unit according to any of aspects 1 to 12, wherein the rolling-element bearing is a ball bearing.

According to an aspect 14 the present invention preferably refers to the electrostatic discharge unit according to any of aspects 1 to 13, wherein the mountings of at least one electrostatic discharge subunit are connected to a conductive rail, conductive frame or combinations thereof and wherein said conductive rail, conductive frame or combinations thereof is grounded.

According to an aspect 15 the present invention preferably refers to the electrostatic discharge unit according to any of aspects 1 to 14, wherein average electrical resistance of the electrostatic discharge subunits contained in the electrostatic discharge unit is between 5 . 10³ and 5 . 10⁸ Ohm per metre length of the transport rollers, based on the average resistances of the transport roller systems.

According to an aspect 16 the present invention preferably refers to the electrostatic discharge unit according to any of aspects 1 to 15, wherein the mounting contains at least an inner part and an outer part, wherein the inner part and the outer part are made from different materials.

According to an aspect 17 the present invention preferably refers to the electrostatic discharge unit according to any of aspects 1 to 16, wherein at least 3 electrostatic discharge subunits independently from each other provide at most 4, preferably at most 3, transport rollers below the transport plane.

According to an aspect 18 the present invention preferably refers to the electrostatic discharge unit according to any of aspects 1 to 17, wherein at least 3 electrostatic discharge subunits independently from each other contain at least 2, preferably at least 3, even more preferred at least 4, transport roller systems.

According to an aspect 19 the present invention preferably refers to the electrostatic discharge unit according to any of aspects 1 to 18, wherein the number of transport roller systems is at least 1.3 times, preferably at least 1.5 times, even more preferred at least 1.9 times, the number of discharge paths.

According to an aspect 20 the present invention preferably refers to the electrostatic discharge unit according to any of aspects 1 to 21, wherein at least 3 electrostatic discharge subunits are located next to each other, and wherein at most one transport roller not being part of an electrostatic discharge subunit is located between the transport rollers below the transport plane of the electrostatic discharge subunits.

According to an aspect 21 the present invention preferably refers to the electrostatic discharge unit according to any of aspects 1 to 20, wherein the organic polymeric coating of the polymer coated metal, preferably stainless steel, rollers contain less than 10 wt.-% additives like fillers and plasticizers, based on the total weight of the organic polymeric coating.

According to an aspect 22 the present invention preferably refers to the electrostatic discharge unit according to any of aspects 1 to 21, wherein the organic polymeric coating of the polymer coated metal, preferably stainless steel, rollers contain at least 90 wt.-%, more preferred at least 95 wt.-%, even more preferred at least 99 wt.-%, of the organic polymer, based on the total weight of the organic polymeric coating

According to an aspect 23 the present invention preferably refers to the electrostatic discharge unit according to any of aspects 1 to 22, wherein at least 90 wt.-%, preferably at least 95 wt.-%, even more preferred at least 99 wt.-%, of the organic polymer is selected from the group consisting of EPDM, NBR, CR, VITON, mixtures thereof or combinations thereof, based on the total amount of organic polymeric polymer.

According to an aspect 24 the present invention preferably refers to the electrostatic discharge unit according to any of aspects 1 to 23, wherein each discharge path is connected to at most 3, preferably at most 2, transport rollers being aligned next to each other in the transportation direction.

According to an aspect 25 the present invention preferably refers to the electrostatic discharge unit according to any of aspects 1 to 24, wherein the average thickness of the organic polymeric coating of the polymer coated metal, preferably stainless steel, transport rollers adapted to contact the substrate is less than 5 mm.

According to an aspect 26 the present invention preferably refers to the electrostatic discharge unit according to any of aspects 1 to 25, wherein the average thickness of the organic polymeric coating of the polymer coated metal, preferably stainless steel, transport rollers adapted to contact the substrate is at least 1 mm.

According to an aspect 27 the present invention preferably refers to the electrostatic discharge unit according to any of aspects 1 to 26, wherein the metal, preferably stainless steel, transport rollers or polymer coated metal, preferably stainless steel, transport rollers are pipes.

According to an aspect 28 the present invention preferably refers to the electrostatic discharge unit according to any of aspects 1 to 27, wherein at least one gas supply element is located around the transport rollers.

According to an aspect 29 the present invention preferably refers to the electrostatic discharge unit according to any of aspects 1 to 28, wherein the at least one gas supply element contains an end part and at least 90 % of the surface of the inside of the last 30 cm of said end part are made from an electrical conductive material and said surface on the inside of the end part is grounded.

According to an aspect 30 the present invention preferably refers to the electrostatic discharge unit according to any of aspects 1 to 29, wherein at least 90 %, preferably at least 95 %, more preferred at least 99 %, even more preferred 100 %, of the inside of the at least one gas supply element from the base of the gas supply element to its outlet is made from an electrical conductive material, the base of the gas supply element is grounded and
- at least the last 30 cm of the end part are electrically connected to the base, or
- said at least 30 cm of the end part are separately grounded.

According to an aspect 31 the present invention preferably refers to a module of a treatment device containing a horizontal transport system for transporting a substrate, wherein the horizontal transport system contains at least one electrostatic discharge unit according to any of aspects 1 to 30.

According to an aspect 32 the present invention preferably refers to the module according to aspect 31, wherein the horizontal transport system for transporting a substrate is based on transport rollers being arranged parallel to each other in direction of the transportation route.

According to an aspect 33 the present invention preferably refers to the module according to any of aspects 31 to 32, wherein the module contains only 2, preferably only 1, electrostatic discharge units according to any of aspects 1 to 30.

According to an aspect 34 the present invention preferably refers to the module according to any of aspects 31 to 33, wherein more than 50 %, more preferred more than 70 %, even more preferred more than 90 %, of the transport rollers are part of a electrostatic discharge unit according to any of aspects 1 to 30.

According to an aspect 35 the present invention preferably refers to the module according to any of aspects 31 to 34, wherein the transport rollers are not in contact with a liquid during operating said module.

According to an aspect 36 the present invention preferably refers to a treatment device containing at least one electrical discharge unit according to any of aspects 1 to 30 or at least one module according to any of aspects 31 to 35.

According to an aspect 37 the present invention preferably refers to a method for electrical discharging a substrate, wherein the substrate is transported using at least one electrical discharge unit according to any of aspects 1 to 30 or at least one module according to any of aspects 31 to 35.

According to an aspect 38 the present invention preferably refers to the method according to aspect 37, wherein the substrate is transported while being in a dry state.

According to an aspect 39 the present invention preferably refers to the method according to any of aspects 37 to 38, wherein the substrate includes a guiding element located on at least one, preferably at least two, sides of the substrate, covering less than 10 % of the surface of the substrate.

According to an aspect 40 the present invention preferably refers to a use of at least one electrical discharge unit according to any of aspects 1 to 30 or at least one module according to any of aspects 31 to 35 for electrical discharging a substrate.

According to an aspect 41 the present invention preferably refers to a use of at least one electrical discharge unit according to any of aspects 1 to 30 or at least one module according to any of aspects 31 to 35 for the production of a printed circuit board, a printed circuit foil, a semiconductor wafer, a solar cell or a photoelectric cell.

The following non-limiting examples are provided to illustrate preferred embodiments of the present invention and to facilitate understanding of the invention, but are not intended to limit the scope of the invention, which is defined by the claims appended hereto.

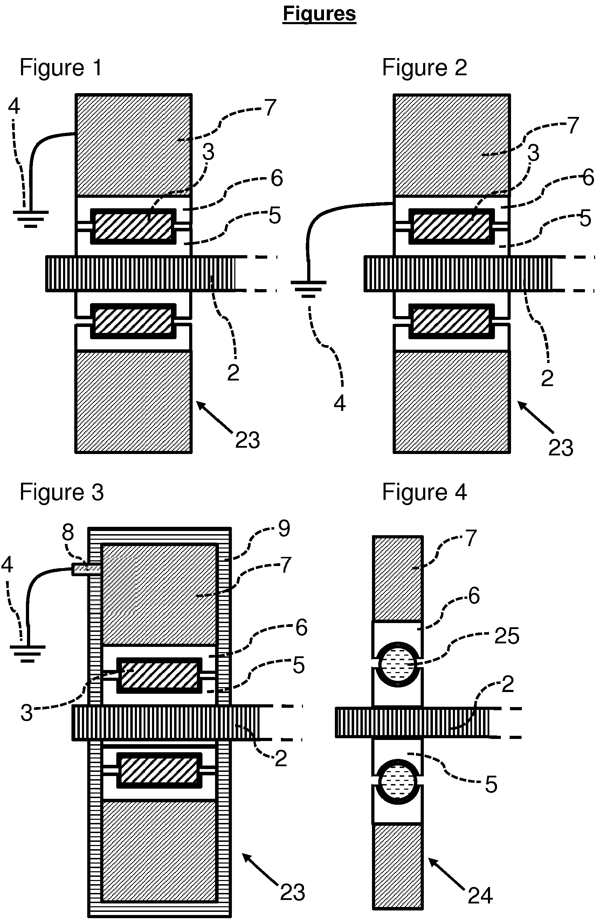

Figure 1 shows a schematic drawing of a rolling-element bearing containing an inner bearing (5) and outer bearing (6) of the inner part of the rolling-element bearing surrounding the axis (2) of the transport roller. Around this inner part of the rolling-element bearing (23) an outer part (7) is arranged. Herein, the grounding (4) is attached to the outer part (7) of the rolling element bearing (23).

Figure 2 shows a schematic drawing of a rolling-element bearing (23) containing inner bearing (5), outer bearing (6), outer part (7) and grounding (4) surrounding the axis (2) of the transport roller. H the grounding (4) is attached to the inner part of the rolling-element bearing (23).

Figure 3 shows a schematic drawing of a rolling-element bearing (23) similar to figure 1 and 2 containing inner bearing (5), outer bearing (6), outer part (7) and grounding (4) surrounding the axis (2) of the transport roller. Herein the grounding (4) is connected to a conductive element (8). Said conductive element (8) connects the outer part (7) to the grounding (4) through the outer layer (9), wherein said outer layer (9) surrounds the inner part and outer part (7) of the rolling-element bearing (23).

Figure 4 shows a schematic drawing of a ball bearing (24) surrounding the axis (2) of a transport roller (1). Similar to the rolling-element bearing from, for example, Figure 1 it contains an inner bearing (5) and outer bearing (6) of the inner part of the bearing surrounding the balls (25). Furthermore, it contains an outer part (7) of the ball bearing (24) surrounding said inner part (14). The connection to the grounding is not explicitly disclosed, but can be, for example, carried out accordingly as disclosed for the rolling-element bearing from Figure 1 to 3.

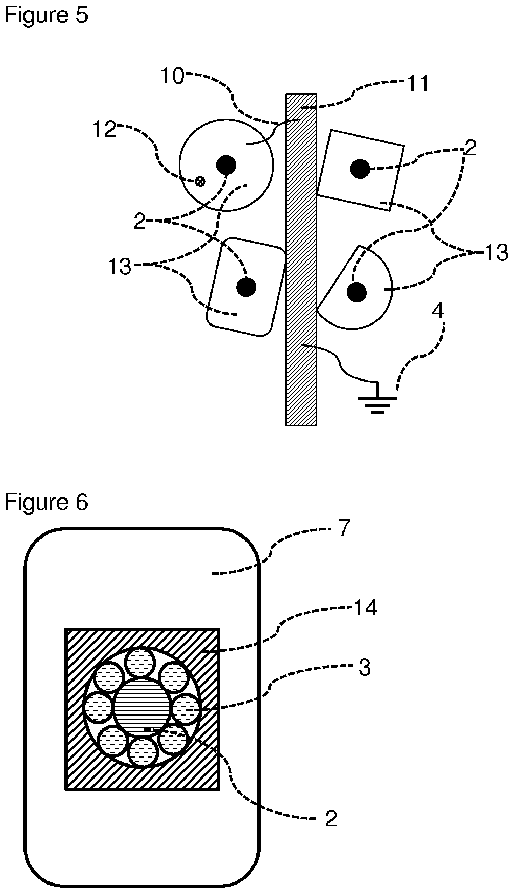

Figure 5 shows a schematic drawing of different types of mountings (13) surroundings the axis (2) of multiple transport rollers. Herein, the rotation of the mounting is reduced or prevented by means of fixation or choosing a specific outer form of said mountings (13). On the top left the mounting provides a round form. Rotation of said mounting (13) is prevented by a fixation (12). Said mounting (13) is connected to the conductive rail (11) using a cable (10), which in turn is connected to the grounding (4). The other three mountings (13) (bottom left, bottom right and top right) exemplarily show different types of outer forms stopping the rotation of the mounting (13) by contacting the conductive rail (11) with an edge. Simultaneously a conductive path is established allowing the charges to be conducted from the axis (2) to the conductive rail (11).

Figure 6 shows a schematic drawing of a cross section of a rolling-element bearing providing an inner part (14) containing rolling elements (3) and outer part (7). Herein, the inner part (14) is surrounding the axis (2) of a transport roller.

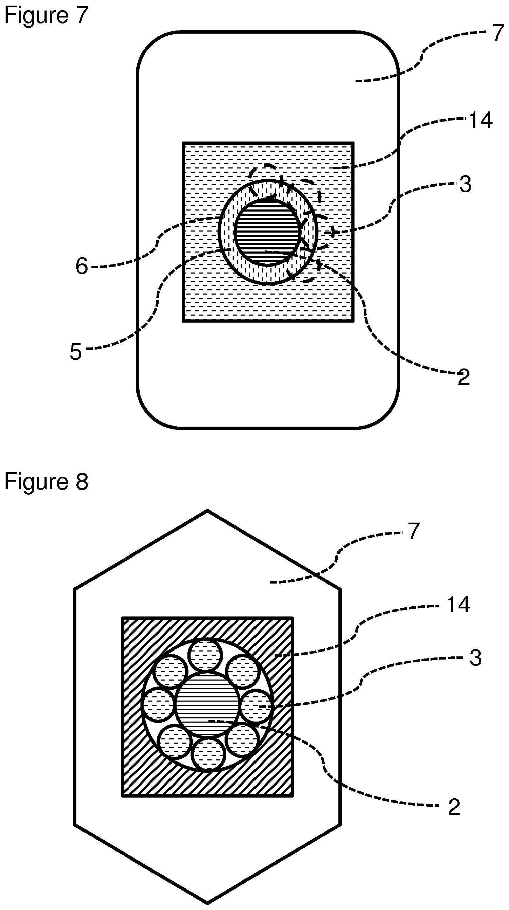

Figure 7 shows a schematic drawing of a side view of the rolling-element bearing of Figure 6 containing rolling elements (3), inner bearing (5) and outer bearing (6) of the inner part (14), and outer part (7) surrounding the axis (2) of the transport roller. Herein, only a few of the rolling elements (3) are shown by means of discontinuous lines.

Figure 8 exemplarily shows a schematic drawing of a rolling-element bearing containing rolling elements (3), inner part (14) and outer part (7) surrounding the axis (2) of a transport roller.

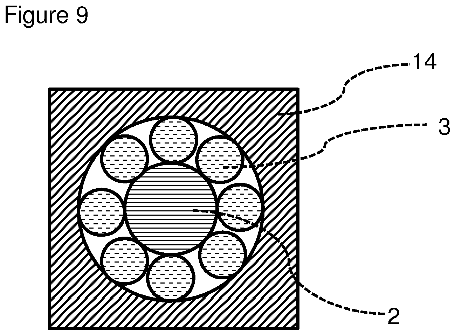

Figure 9 shows the schematic drawing of another embodiment of the mounting similar to the mounting of Figure 6 showing the rolling elements (3) and the inner part (14) surrounding the axis (2) of the transport roller. In this case, the mounting provides no outer part.

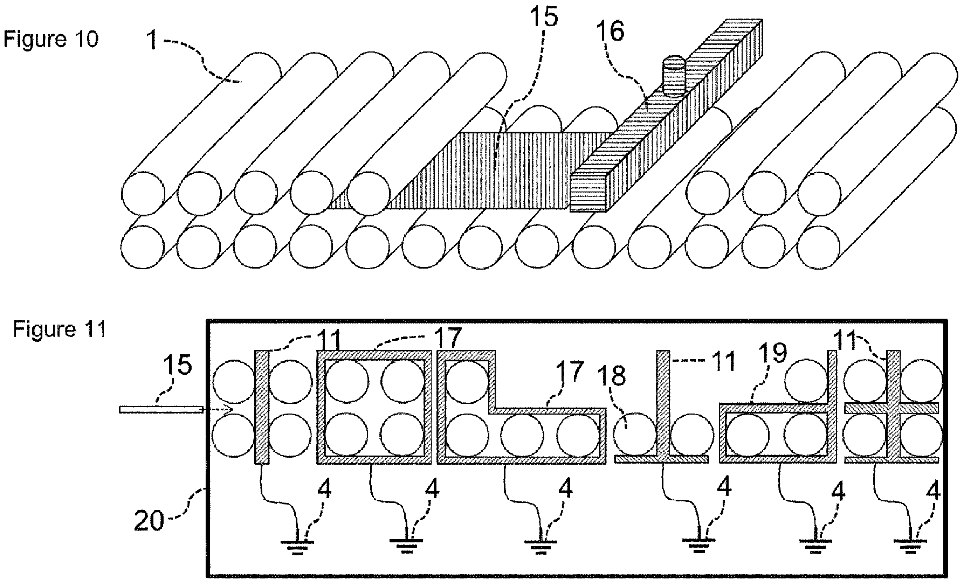

Figure 10 shows a schematic drawing of an electrostatic discharge unit containing multiple transport rollers (1), a substrate (15) and a gas supply element (16). For simplification only one transport roller has been labelled. Herein, the substrate is transported between the transport rollers (1) being arranged below and above the transport plane. In the central area the transport rollers (1) are arranged only below the substrate (15), wherein the gas supply element (16) directs a gas stream onto the surface of said substrate (15).

Figure 11 shows a schematic drawing of an inventive module (20) containing transport roller systems (18) for transporting the substrate (15) through said module (20). Herein, for the sake of simplification only one transport roller system (18) is labelled and the transport roller systems (18) are reduced to a circle representing the mounting (13) on the front side and the transport roller (1) behind it. The substrate (15) is transported between the transport rollers (1) being arranged above and below the transport plane, wherein the charges accumulating on their surfaces are conducted from the mounting (13) of the corresponding transport rollers system (18) to a conductive rail (11), a conductive frame (17) or a combination of a conductive rail and conductive frame (19) to the grounding (4).

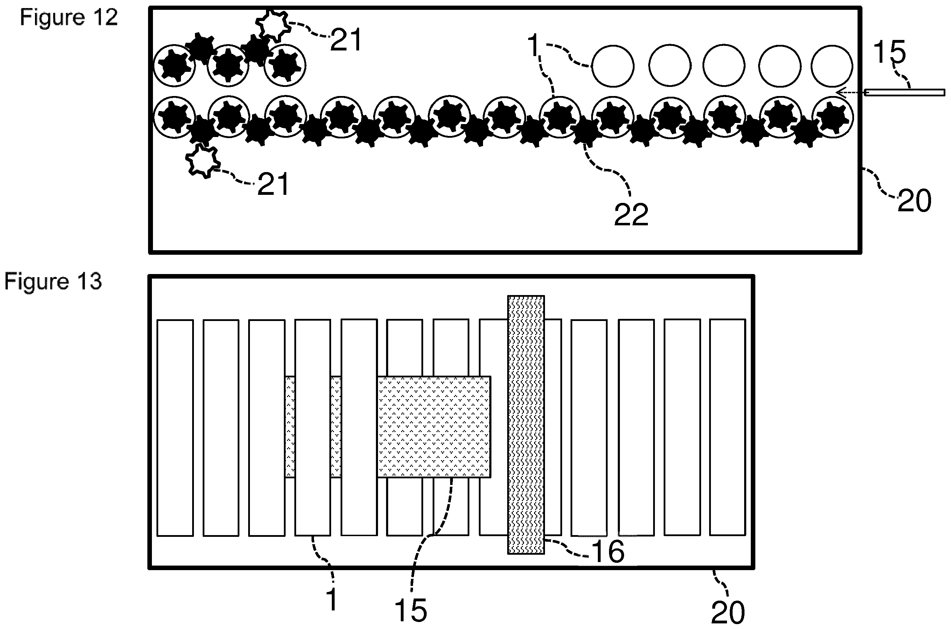

Figure 12 shows a schematic drawing of a module (20) like shown in Figure 11 viewed from the opposing side. Herein, gear wheels (22) are shown used to rotate the transport rollers (1). For the reason of simplification only one gear wheel and two transport rollers are labelled. Said gear wheels are moved either directly or indirectly be a propulsion element (21) as shown in Figure 12. Such propulsion element (21) generalized by a gear wheel without filling in Figure 12 introduces a movement into the row of gear wheels (22) which on the other hand rotate the transport rollers (1) transporting the substrate (15). According to Figure 12 the gear wheels (22) below and above the transport plane contain separate propulsion elements (21), however, the propulsion of all gear wheels (22) might also result from a single propulsion element (21).

Figure 13 shows schematic drawing of an exemplary module (20) as shown in Figures 11 and 12 viewed from the top. For sake of simplification only one transport roller (1) has been labelled. The substrate (15) is moved through the module (20), wherein Figure 13 shows said substrate (15) being partially covered by some transport rollers (1). Arranged next to the substrate (15) is a gas supply element (16) for directing a gas stream onto the surface of the substrate (15).

While the principles of the invention have been explained in relation to certain particular embodiments, and are provided for purposes of illustration, it is to be understood that various modifications thereof will become apparent to those skilled in the art upon reading the specification. Therefore, it is to be understood that the invention disclosed herein is intended to cover such modifications as fall within the scope of the appended claims. The invention is defined by the appended claims.

### Reference Signs

1: transport roller
2: axis of transport roller
3: rolling-element
4: grounding
5: inner bearing of the inner part of the rolling-element bearing
6: outer bearing of the inner part of the rolling-element bearing
7: outer part of rolling-element bearing
8: conductive element for contacting the outer part to the grounding
9: outer layer
10: cable
11: conductive rail
12: fixation of the mounting
13: mounting
14: inner part of the rolling-element bearing
15: substrate
16: gas supply element
17: conductive frame
18: transport roller system
19: combination conductive rail and conductive frame
20: module
21: propulsion element
22: gear wheel used rotate the transport rollers
23: rolling-element bearing
24: ball bearing
25: ball

## Claims

1. An electrostatic discharge unit containing at least one electrostatic discharge subunit,
wherein the at least one electrostatic discharge subunit contains at least one transport roller system (18) and at least one discharge path,
wherein each transport roller system (18) independently from each other contains one transport roller (1) and at least one mounting (13) containing a rolling-element bearing (23),
wherein the transport rollers (1) are selected from metal transport rollers (1) or polymer coated metal transport rollers (1),
and wherein the electrostatic discharge subunit is adapted to conduct the charge from the surface of the transport roller (1) through the rolling-element bearing to the discharge path; wherein the electrical resistance of the mounting being adapted to conduct the charges towards the grounding lies within the range from 10³ to 10⁹ Ohm; and wherein the rolling-element bearing is a ball bearing.

2. The electrostatic discharge unit according to claim 1, wherein the rolling-element bearing (23) contain an organic polymer, and
wherein electrostatic discharge unit is adapted to conduct the charge from the surface of the transport roller (1) through the organic polymer of the rolling-element bearing (23) to the discharge path.

3. The electrostatic discharge unit according to any of claims 1 to 2, wherein the electrostatic discharge unit contains at least 3 electrostatic discharge subunits each independently from each other containing 1, 2, 3, 4, 5 or 6 transport roller systems (18).

4. The electrostatic discharge unit according to any of claims 1 to 3, wherein at least one of the mountings (13) of the electrostatic discharge subunits of the electrostatic discharge unit is connected to a conductive rail (11), conductive frame (17) or combinations thereof and wherein said conductive rail (11), conductive frame (17) or combinations thereof is grounded.

5. The electrostatic discharge unit according to claim 4, wherein the conductive rail (11), conductive frame (17) or combinations thereof are made of metal.

6. The electrostatic discharge unit according to any of claims 2 to 5, wherein the organic polymer of the rolling-element bearing (23) is a self-lubricating organic polymer.

7. The electrostatic discharge unit according to any of claims 1 to 6, wherein the number of transport roller systems (18) is at least 1.3 times the number of discharge paths.

8. The electrostatic discharge unit according to any of claims 1 to 7, wherein at least 3 electrostatic discharge subunits are located next to each other, wherein at most one transport roller (1) not being part of an electrostatic discharge subunit is located between the transport rollers (1) below the transport plane of the electrostatic discharge subunits.

9. The electrostatic discharge unit according to any of claims 1 to 8, wherein the average thickness of the organic polymeric coating of the polymer coated metal transport rollers (1) adapted to contact the substrate is less than 5 mm.

10. The electrostatic discharge unit according to any of claims 1 to 9, wherein at least one gas supply element 16 is located around the transport rollers (1).

11. Module 20 of a treatment device containing a horizontal transport system for transporting a substrate (15), wherein the horizontal transport system contains at least one electrostatic discharge unit according to any of claims 1 to 10.

12. Method for electrical discharging a substrate (15), wherein the substrate (15) is transported using at least one electrical discharge unit according to any of claims 1 to 10 or at least one module (20) according to claim 11.

13. Use of at least one electrical discharge unit according to any of claims 1 to 10 or at least one module (20) according to claim 11 for the production of a printed circuit board, a printed circuit foil, a semiconductor wafer, a solar cell or a photoelectric cell.

## Patentansprüche

1. Elektrostatische Entladungseinheit, die mindestens eine elektrostatische Entladungsuntereinheit enthält,
wobei die mindestens eine elektrostatische Entladungsuntereinheit mindestens ein Transportwalzensystem (18) und mindestens eine Entladungsstrecke enthält,
wobei jedes Transportwalzensystem (18) unabhängig voneinander eine Transportwalze (1) und mindestens eine ein Wälzlager (23) enthaltende Halterung (13) enthält,
wobei die Transportwalzen (1) aus Metalltransportwalzen (1) oder polymerbeschichteten Metalltransportwalzen (1) ausgewählt sind,
und wobei die elektrostatische Entladungsuntereinheit angepasst ist, die Ladung von der Oberfläche der Transportwalze (1) durch das Wälzlager zur Entladungsstrecke zu leiten; wobei der elektrische Widerstand der Halterung, die angepasst ist, die Ladungen zur Erdung zu leiten, im Bereich von 10³ bis 10⁹ Ohm liegt; und wobei das Wälzlager ein Kugellager ist.

2. Elektrostatische Entladungseinheit nach Anspruch 1, wobei das Wälzlager (23) ein organisches Polymer enthält, und
wobei die elektrostatische Entladungseinheit angepasst ist, die Ladung von der Oberfläche der Transportwalze (1) durch das organische Polymer des Wälzlagers (23) zu der Entladungsstrecke zu leiten.

3. Elektrostatische Entladungseinheit nach einem der Ansprüche 1 bis 2, wobei die elektrostatische Entladungseinheit mindestens 3 elektrostatische Entladungsuntereinheiten enthält, die jeweils unabhängig voneinander 1, 2, 3, 4, 5 oder 6 Transportwalzensysteme (18) enthalten.

4. Elektrostatische Entladungseinheit nach einem der Ansprüche 1 bis 3, wobei mindestens eine der Halterungen (13) der elektrostatischen Entladungsuntereinheiten der elektrostatischen Entladungseinheit mit einer leitenden Schiene (11), einem leitenden Rahmen (17) oder Kombinationen davon verbunden ist und wobei die leitende Schiene (11), der leitende Rahmen (17) oder Kombinationen davon geerdet sind.

5. Elektrostatische Entladungseinheit nach Anspruch 4, wobei die leitende Schiene (11), der leitende Rahmen (17) oder Kombinationen davon aus Metall hergestellt sind.

6. Elektrostatische Entladungseinheit nach einem der Ansprüche 2 bis 5, wobei das organische Polymer des Wälzlagers (23) ein selbstschmierendes organisches Polymer ist

7. Elektrostatische Entladungseinheit nach einem der Ansprüche 1 bis 6, wobei die Anzahl der Transportwalzensysteme (18) mindestens das 1,3-Fache der Anzahl der Entladungsstrecken beträgt.

8. Elektrostatische Entladungseinheit nach einem der Ansprüche 1 bis 7, wobei mindestens 3 elektrostatische Entladungsuntereinheiten nebeneinander angeordnet sind, wobei höchstens eine Transportwalze (1), die kein Bestandteil einer elektrostatischen Entladungsuntereinheit ist, zwischen den Transportwalzen (1) unter der Transportebene der elektrostatischen Entladungsuntereinheiten angeordnet ist.

9. Elektrostatische Entladungseinheit nach einem der Ansprüche 1 bis 8, wobei die durchschnittliche Dicke der organischen Polymerbeschichtung der polymerbeschichteten Metalltransportwalzen (1), die zum Kontakt mit dem Substrat angepasst sind, weniger als 5 mm beträgt.

10. Elektrostatische Entladungseinheit nach einem der Ansprüche 1 bis 9, wobei sich mindestens ein Gasversorgungselement (16) um die Transportwalzen (1) herum befindet.

11. Modul (20) einer Behandlungsvorrichtung, das ein horizontales Transportsystem zum Transportieren eines Substrats (15) enthält, wobei das horizontale Transportsystem mindestens eine elektrostatische Entladungseinheit nach einem der Ansprüche 1 bis 10 enthält.

12. Verfahren zum elektrischen Entladen eines Substrats (15), wobei das Substrat (15) mit mindestens einer elektrischen Entladeeinheit nach einem der Ansprüche 1 bis 10 oder mindestens einem Modul (20) nach Anspruch 11 transportiert wird.

13. Verwendung mindestens einer elektrischen Entladungseinheit nach einem der Ansprüche 1 bis 10 oder mindestens eines Moduls (20) nach Anspruch 11 zur Herstellung einer gedruckten Leiterplatte, einer gedruckten Schaltungsfolie, eines Halbleiterwafers, einer Solarzelle oder einer photoelektrischen Zelle.

## Revendications

1. Unité de décharge électrostatique contenant au moins une sous-unité de décharge électrostatique,
dans laquelle l'au moins une sous-unité de décharge électrostatique contient au moins un système de rouleau de transport (18) et au moins un chemin de décharge, dans laquelle chaque système de rouleau de transport (18), indépendamment de chaque autre, contient un rouleau de transport (1) et au moins un montage (13) contenant un roulement (23),
dans laquelle les rouleaux de transport (1) sont choisis parmi les rouleaux de transport métalliques (1) ou les rouleaux de transport métalliques à revêtement polymère (1),
et dans laquelle la sous-unité de décharge électrostatique est adaptée pour conduire la charge depuis la surface du rouleau de transport (1) à travers le roulement jusqu'au chemin de décharge ; dans laquelle la résistance électrique du montage adapté pour conduire la charge vers la terre se situe dans la gamme de 10³ à 10⁹ ohms ; et dans laquelle le roulement est un roulement à billes.

2. Unité de décharge électrostatique selon la revendication 1, le roulement (23) contenant un polymère organique, et
l'unité de décharge électrostatique étant adaptée pour conduire la charge depuis la surface du rouleau de transport (1) à travers le polymère organique du roulement (23) jusqu'au chemin de décharge.

3. Unité de décharge électrostatique selon l'une quelconque des revendications 1 à 2, l'unité de décharge électrostatique contenant au moins 3 sous-unités de décharge électrostatique, chacune contenant, indépendamment de chaque autre, 1, 2, 3, 4, 5 ou 6 systèmes de rouleau de transport (18).

4. Unité de décharge électrostatique selon l'une quelconque des revendications 1 à 3, dans laquelle au moins un des montages (13) des sous-unités de décharge électrostatique de l'unité de décharge électrostatique est relié à un rail conducteur (11), un cadre conducteur (17) ou des combinaisons de ceux-ci, et dans laquelle lesdits rail conducteur (11), cadre conducteur (17) ou combinaisons de ceux-ci sont mis à la terre.

5. Unité de décharge électrostatique selon la revendication 4, dans laquelle le rail conducteur (11), le cadre conducteur (17) ou les combinaisons de ceux-ci sont constitués de métal.

6. Unité de décharge électrostatique selon l'une quelconque des revendications 2 à 5, dans laquelle le polymère organique du roulement (23) est un polymère organique autolubrifiant.

7. Unité de décharge électrostatique selon l'une quelconque des revendications 1 à 6, dans laquelle le nombre de systèmes de rouleau de transport (18) est égal à au moins 1,3 fois le nombre de chemins de décharge.

8. Unité de décharge électrostatique selon l'une quelconque des revendications 1 à 7, dans laquelle au moins 3 sous-unités de décharge électrostatique sont situées les unes à côté des autres, dans laquelle au maximum un rouleau de transport (1) ne faisant pas partie d'une sous-unité de décharge électrostatique est situé entre les rouleaux de transport (1) sous le plan de transport des sous-unités de décharge électrostatique.

9. Unité de décharge électrostatique selon l'une quelconque des revendications 1 à 8, dans laquelle l'épaisseur moyenne du revêtement polymère organique des rouleaux de transport métalliques à revêtement polymère (1) adaptés pour être en contact avec le substrat est inférieure 5 mm.

10. Unité de décharge électrostatique selon l'une quelconque des revendications 1 à 9, dans laquelle au moins un élément d'alimentation en gaz (16) est situé autour des rouleaux de transport (1).

11. Module (20) d'un dispositif de traitement contenant un système de transport horizontal pour transporter un substrat (15), le système de transport horizontal contenant au moins une unité de décharge électrostatique selon l'une quelconque des revendications 1 à 10.

12. Procédé de décharge électrique d'un substrat (15), dans lequel le substrat (15) est transporté au moyen d'au moins une unité de décharge électrique selon l'une quelconque des revendications 1 à 10 ou d'au moins un module (20) selon la revendication 11.

13. Utilisation d'au moins une unité de décharge électrique selon l'une quelconque des revendications 1 à 10 ou d'au moins un module (20) selon la revendication 11 pour la production d'une carte de circuit imprimé, d'une feuille de circuit imprimé, d'une tranche semiconductrice, d'une cellule solaire ou d'une cellule photoélectrique.
